Europäisches Patentamt

(19) European Patent Office

Office européen des brevets

(11) Publication number: **0 320 542 B1**

# (12) EUROPEAN PATENT SPECIFICATION

(45) Date of publication of patent specification:
13.03.91 Bulletin 91/11

(51) Int. Cl.⁵: **H05K 7/10, H01R 23/70**

(21) Application number: 87311010.0

(22) Date of filing: 15.12.87

(54) IC package extracting mechanism used in IC socket.

(43) Date of publication of application:
21.06.89 Bulletin 89/25

(45) Publication of the grant of the patent:
13.03.91 Bulletin 91/11

(84) Designated Contracting States:
DE FR GB IT

(56) References cited:
EP-A- 0 197 376
US-A- 4 193 656
US-A- 4 381 131

(73) Proprietor: Yamaichi Electric MFG. Co., Ltd.
8-16, Chidori 2-chome
Ohta-ku Tokyo (JP)

(72) Inventor: Matsuoka, Noriyuki
29-28, Ohi 4-chome Shinagawa-ku
Tokyo (JP)

(74) Representative: Ben-Nathan, Laurence Albert
et al
Urquhart-Dykes & Lord 91 Wimpole Street
London W1M 8AH (GB)

## Description

This invention relates to an IC package extracting mechanism used in an IC socket in which an IC package can be easily removed from the IC socket.

There has been proposed the so-called zero insertion socket in which an IC socket is provided with a discontacting element or terminal of an IC package, see for example EP-A-0197376. However, in the case the IC package is minute and flat, it is difficult to remove the IC package from the IC socket even when the contact resistance becomes zero because it has few portion which can be grasped. If a pincette or the like is used for the removal, there is possibility that the contact is damaged by mistake. Besides, adoption of a pincette or the like badly spoils the efficiency of the removing work.

As for the above-described conventional IC package removing device, for example, a socket is provided with a sink-and-float table for mounting thereon an IC package held by a spring so that the IC package will be pushed up. However, since a pushing-up force is normally applied to the IC package by the spring, the IC package tends to be floated even if it is pressed by a pressure cover and thus unstable. In addition, since the pushing-up amount is limited, a large pushing-up amount is difficult to obtain and designing of the spring strength, expanding amount, or the like is difficult to obtain.

There has also been proposed another IC package removing device in which a cover for pressing an IC package is provided with a suction cup member so that the attachment of the suction cup to the upper surface of the IC package enables to open the cover and to extract the IC package. However, it takes much time and labor to remove the IC package from the suction cup. On the contrary, if the suction force is too small, the IC package tends to come off. In addition, there is such an inconvenience as that the suction cup becomes deteriorated and unable to be firmly attached to the IC package.

The present invention was accomplished in order to eliminate the above-described inconveniences inherent in the previously proposed devices.

It is therefore a general object of the present invention to provide an IC package extracting mechanism used in an IC socket in which an IC package can be always easily and surely pushed up and a suitable amount of pushing-up work is obtainable to facilitate the extraction of the IC package without invitation of the above-described problems.

Accordingly, there is provided a socket as defined in Claim 1.

The above and other objects, features and advantages of the present invention will become apparent from the following detailed description of a preferred embodiment of the invention with reference to the accompanying drawings, in which :

Fig. 1 is a plan view of an IC socket according to one embodiment of the present invention ;
Fig. 2 (A) is a sectional view taken along the line A-A of Fig. 1 showing a pushed-up state of an IC package ;
Fig. 2 (B) is a sectional view likewise taken along the line A-A of Fig. 1 showing a pushed-down state of the IC package ;
Fig. 2 (C) is a sectional view taken along the line B-B of Fig. 1 showing a pushed-up state of an IC package accommodating framework ;
Fig. 2 (D) is a sectional view likewise taken along the line B-B of Fig. 1 showing a pushed-down state of the IC package accommodating framework ;
Fig. 3 is plan view of a socket substrate according to one embodiment of the present invention ;
Fig. 4 is a sectional view taken on the line C-C of Fig. 3 ;
Fig. 5 is a sectional view taken on the line D-D of Fig. 3 ;
Fig. 6 is a plan view of the IC package accommodating framework ;
Fig. 7 is a side view thereof ;
Fig. 8 is a sectional view taken along the line E-E of Fig 6 ;
Fig. 9 is a rear view thereof ;
Fig. 10 is an exploded perspective view of an IC package mounting table and a seesaw lever ;
Fig. 11 is a perspective view thereof but when they are assembled ;
Fig. 12 (A) is a sectional view of a socket showing a pushed-up state of the IC package ;
Fig. 12 (B) is a sectional view of the socket showing a pushed-down state of the IC package ;
Fig. 13 (A) is a sectional view of a socket showing a pushed-up state of an IC package according to second embodiment of the present invention ;
Fig. 13 (B) is likewise a sectional view of the socket showing a pushed-down state of the IC package ;
Fig. 14 (A) is a sectional view of a socket showing a pushed-up state of an IC package according to a third embodiment of the present invention ; and
Fig. 14 (B) is likewise a sectional view of the socket showing a pushed-down state of the IC package.

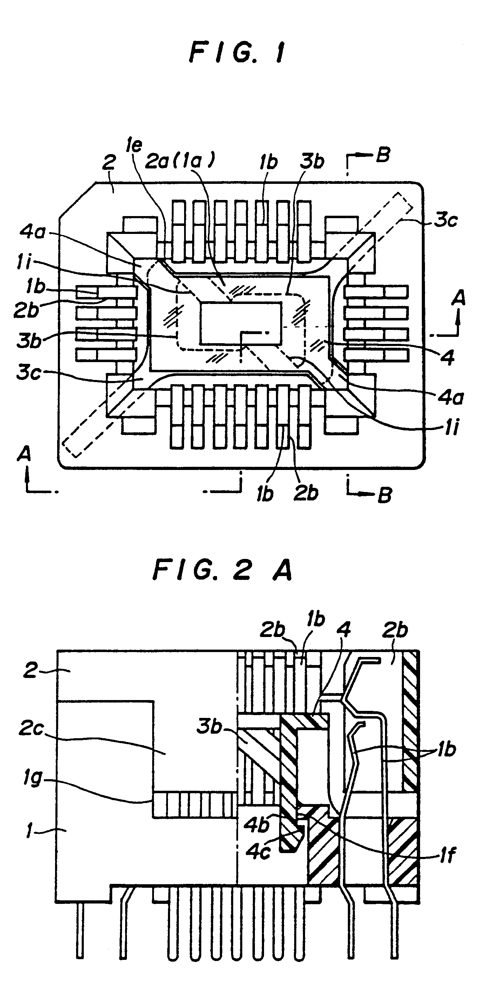

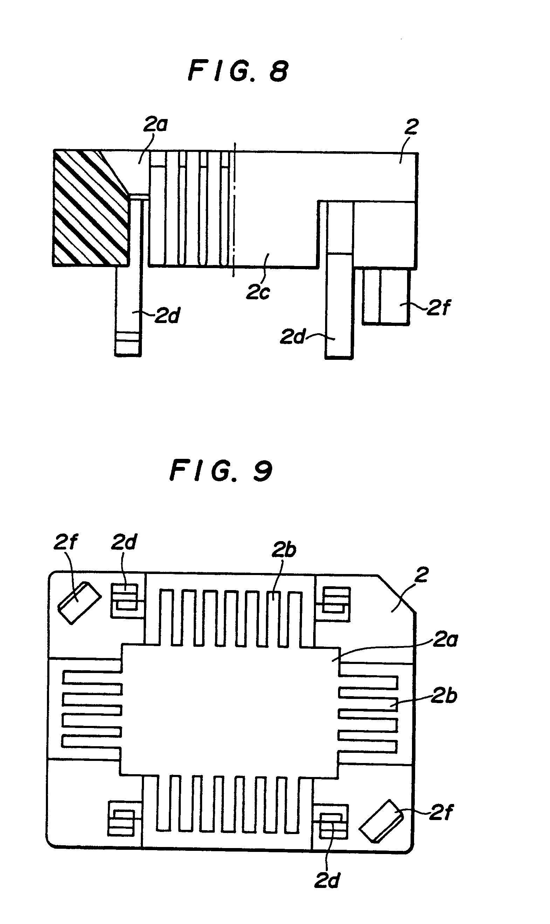

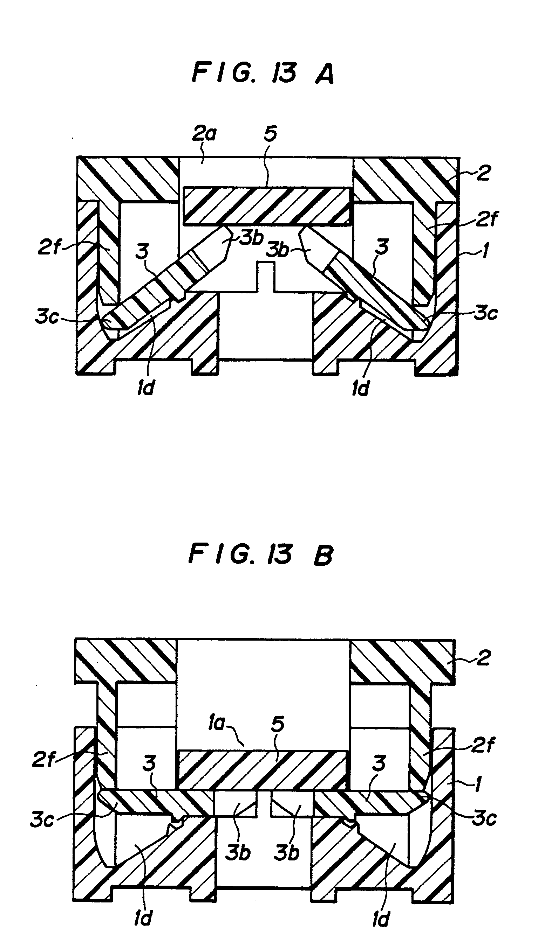

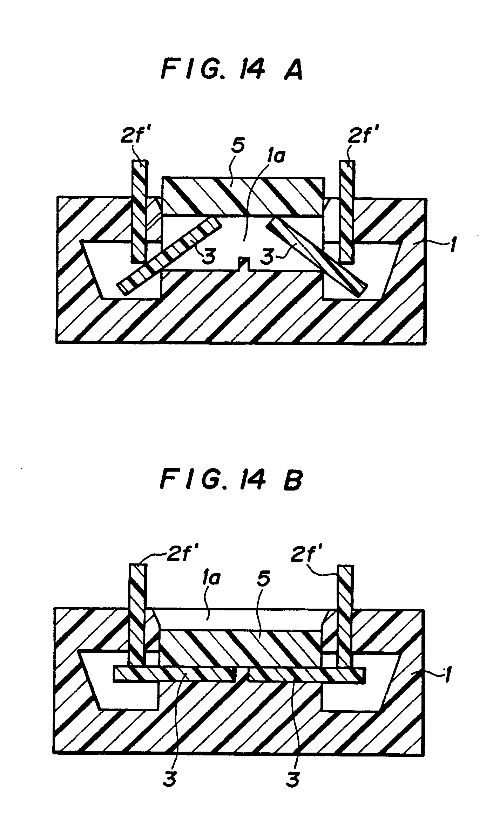

Figs. 1 through 12 illustrate a first embodiment, Fig. 13 illustrate a second embodiment, and Fig. 14 illustrates a third embodiment.

Referring first to Figs. 1 through 12, 1 denotes a socket substrate, 2 denotes a framework, 3 denotes a seesaw lever, and 4 denotes an IC package mounting table.

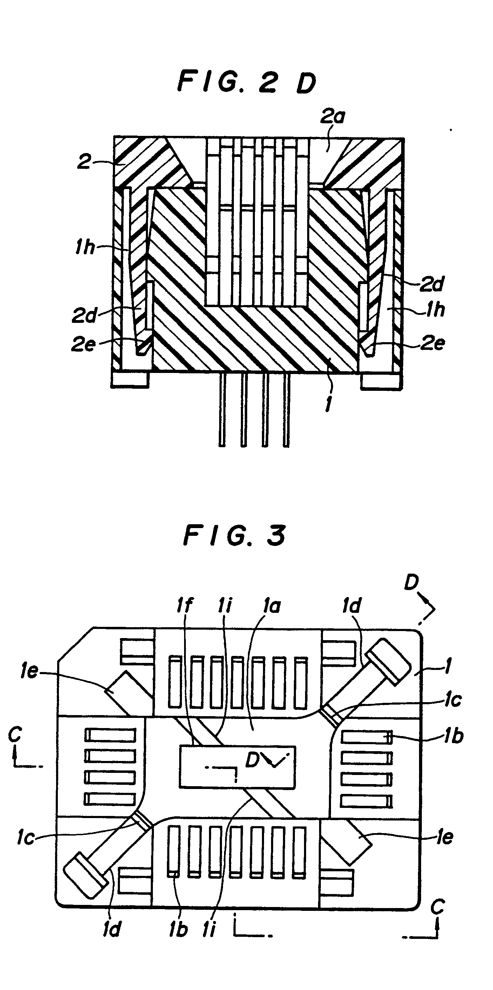

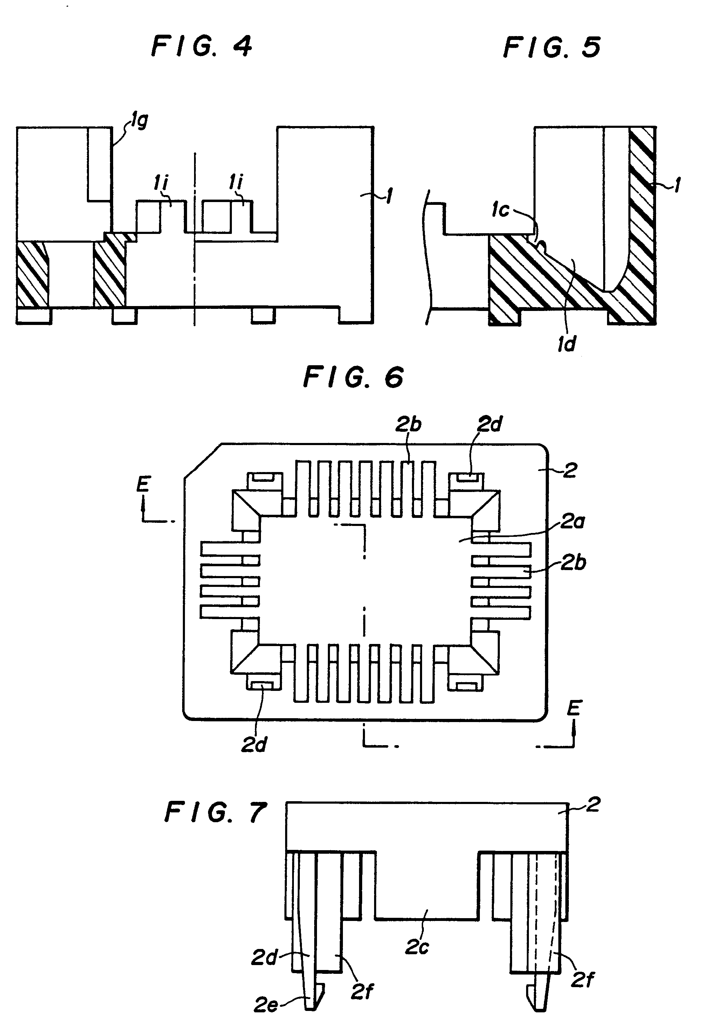

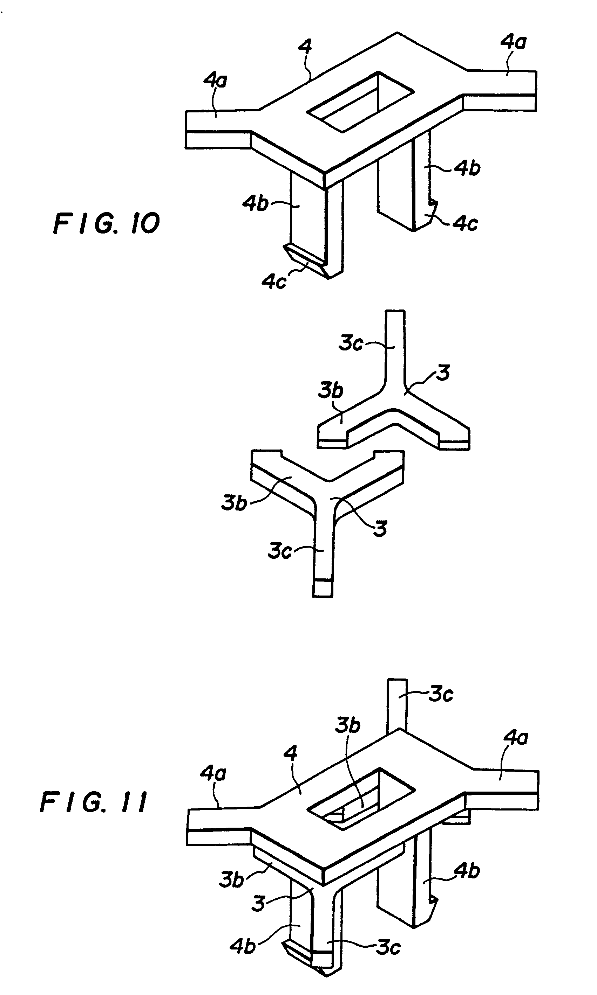

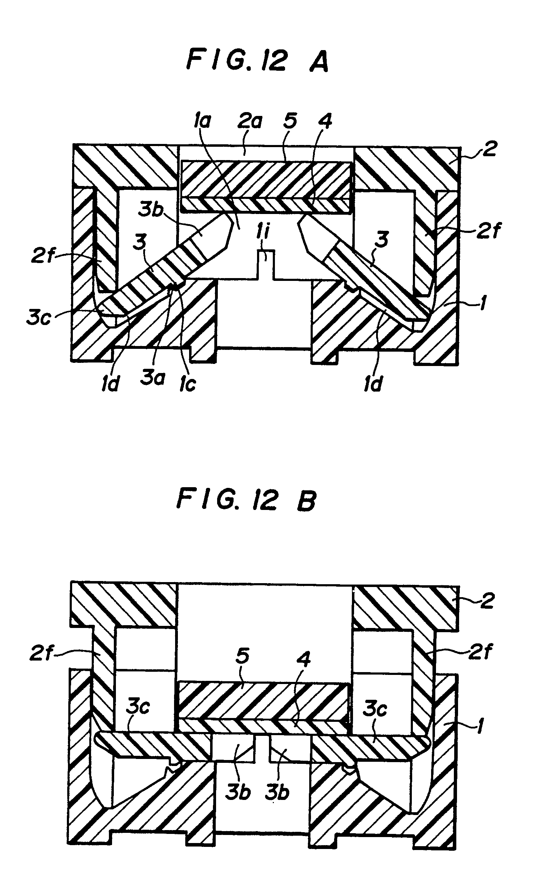

Figs. 3 through 5 show the structure of the socket substrate 1, Figs. 6 through 9 show the structure of the IC package accommodating framework 2, and Figs. 10 and 11 show the structures of the seesaw lever 3

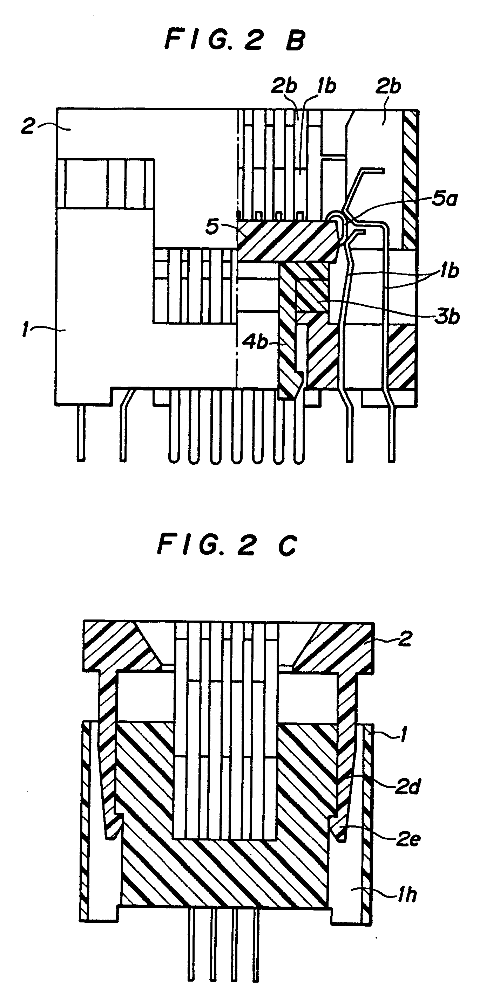

and the IC package mounting table 4. Figs. 1 and 2 show the assemblies of the above-mentioned various component elements.

The socket substrate 1 is provided at the central portion thereof with a generally square-shaped IC package accommodating section 1a and around the entire periphery or along the two sides of the IC package accommodating section 1a with a plurality of contacts 1b which are to be contacted with a plurality of terminals (5a) of an IC package (5). The socket substrate 1 is also provided with the seesaw lever 3 for seesaw movement at every corner of the IC package accommodating section 1a where the rows of the contacts 1b are not formed.

The seesaw lever 3 includes an IC package push-up lever portion 3b extending inside the IC package accommodating section 1a along the sides forming the corner thereof, and a push-down lever portion 3c extending outside of the IC package accommodating section 1a from the corner. The seesaw lever 3 is provided on the central portion thereof with a projection 3a which is to be snugly engaged into an engaging groove 1c which is formed in the corner portion of the IC package accommodating section 1a, so that the push-up lever portion 3b and the push-down lever portion 3c are moved up and down in turn balancing on the snugging portion as the support thereof.

The corner portion of the IC package accommodating section 1a provided with the seesaw lever 3 is formed with a seesaw lever guiding groove 1d directing outside of the corner along the generally diagonal line thereof. The bottom surface of the guiding groove 1d is inclined downwards in the external direction from the engaging groove 1c serving as the support, so that the push-down lever 3c is permitted to be pushed down when the push-down lever 3c is engaged in the guiding groove 1d.

A pair of seesaw levers 3 are disposed on each corner on one diagonal line of the IC package accommodating section 1a. The IC package accommodating section 1a is provided on its bottom surface with a partition wall 1i for partitioning both the seesaw levers 3 in order to prevent the respective seesaw levers from playing within the IC package accommodating section 1a.

Within the IC package accommodating section 1a with the seesaw levers 3 disposed as described, the IC package mounting table 4 of a generally same shape as the IC package accommodating section 1a is contained, and the corner portions of the mounting table (4) are superposed on the upper surfaces of the lever portions 3b. By this, one seesaw lever 3 supports on the push-up lever portion 3b the area along one side forming the corner of the IC package mounting table 4, while the other seesaw lever 3 supports the area along the other side forming the corner of the IC package mounting table 4. The seesaw motion of the seesaw lever 3 causes the IC package mounting table 4 to move up and down. More specifically, the push-up lever portion 3b is sprung up by pushing down the push-down lever portion 3c of the seesaw lever 3 thereby to push up both ends of the IC package mounting table 4 and an IC package 5 mounted thereon to bring them to the discontacting position (see Fig. 15 (A)), and, on the contrary, the IC package mounting table 4 is lowered by pushing down the IC package 5 thereby to turn the push-up lever portion 3b downwards to spring up the pushdown lever portion 3c to bring it to the contacting position (see Fig. 12 (B)).

In order to have the IC package mounting table perform the vertical movement smoothly, a guiding piece 4a projecting sidewards from a pair of angle portions on the diagonal line of the IC package mounting table 4 is snugly engaged in a guiding groove 1e formed in the external direction from the corner portions on the diagonal line of the IC package accommodating section 1a.

A plurality of legs 4b are erected downwards from the IC package mounting table 4, and the legs 4b are inserted along the inner wall of a window 1f formed in the central portion of the IC package accommodating section 1a, so that when the IC package mounting table 4 is lifted up, a hook 4c formed on the front ends of the legs 4b are engaged with the peripheral portion of the wall defining the window 1f to regulate the lifting amount thereof and to prevent the same from coming off.

The framework 2 is provided on the socket substrate 1 which is formed such as described above.

The framework 2 has an opening 2a directly above the IC package accommodating section 1a of the socket substrate 1. The opening 2a are formed at four sides or two sides thereof with a plurality of contact accommodating grooves 2b. By placing the framework 2 on the socket substrate 1, the IC package accommodating section 1a and the opening 2a are brought to positions vertically corresponding to each other, and the contact 1b are inserted in the contact accommodating groove 2b.

In order to form the corresponding state of the framework 2, the guiding piece 2c is formed by the side wall of the framework 2, and the guiding piece 2c is snugly engaged in a guiding groove 1g formed in the side wall of the socket substrate 1 to set the position where the framework 2 is provided, and the vertical movement is obtained by serving this as a guige.

Furthermore, a plurality of legs 2d are erected downwards from the framework 2, the legs 2 are inserted into a guiding hole 1h formed in the socket substrate 1 for use of a guide for vertical movement, and a hook 2e formed on the front end of each leg 2d is engaged with a hole wall when lifting to set the lifting position.

Furthermore, as means for rendering a push-down force to the push-down lever portion of the seesaw lever 3, a push-down finger 2f are erected downwards from the framework 2 to bring it into abut contact with the upper surface of the end portion of the push-down lever portion 3c.

As is shown in Fig. 12 (A), when the IC package (5) is loaded or removed, the framework 2 is in a pushed-down state. As a result, the push-down finger 2f pushes and turns the push-down lever portion 3c to spring up the push-up lever portion 3b, thereby to hold the IC package mounting table 4 in its lifted position.

In the above-mentioned state, the IC package 5 is mounted on the IC package mounting table 4 thereby to render the latter a push-down force. As a result, as is shown in Fig. 12 (B), the IC package mounting table 4 turns the push-up lever portion 3b of the seesaw lever 3 downwards, and springs up the push-down lever portion 3c by the reaction thereof, and, at the same time, pushes up the push-down finger 2f of the framework 2 to bring the framework 2 in the pushed-up position.

In the above-mentioned state, terminals 5a arranged on each side of the IC package 5 are resiliently caught from both sides thereof and contacted under pressure by the contacts 1b. That is, they are brought to be contacted with each other.

When the framework 2 is pushed down from the contacting state, the seesaw lever 3 performs the seesaw motion as described. As a result, the IC package mounting table 4 and the IC package 5 mounted thereon are pushed up again in the lifted-position shown in Fig. 12 (A) to cancel the contacted state. In the foregoing state, the IC package 5 can be easily removed from and mounted on the IC package mounting table 4.

Referring now to Fig. 13, a second embodiment of the present invention will be described. In the illustrated embodiment, there is no provision of the IC package mounting table 4 which is used in the first embodiment, and the IC package 5 is directly supported by the push-up lever portion 3b of the seesaw lever 3. By seesaw motion of the seesaw lever 3, the lower contacting position shown in Fig. 13 (A) and the IC package pushed-up position shown in Fig. 13 (B) are optained.

Referring to Fig. 14, a third embodiment of the present invention will be described. In the illustrated embodiment, there is no provision of the framework 2 which is used in the first embodiment, and a push-down finger 2f' is vertically operatably mounted on the socket substrate 1. The front end of the push-down finger 2f' is abutted against and pushed down the push-down lever portion 3c of the seesaw lever 3. The pushing down of the push-down portion 3c of the seesaw lever 3 causes the IC package push-up lever portion of the seesaw lever 3 to spring up to the IC package pushed-up position shown in Fig. 14 (A). On the contrary, the pushing down of the IC package causes the push-down finger 2f' to the pushed-up position shown in Fig. 14 (B).

In the above-described embodiment, the IC package mounting table 4 may of course be used. Furthermore, the push-down finger 2f' and the end portion of the push-down lever portion 3c of the seesaw lever 3 are brought to be contacted with each other as described. In the above-described embodiments, the push-down finger (25) or (25') and the seesaw lever (3) may be linked with each other by a shaft.

As described in the foregoing, a socket substrate is provided with a seesaw lever, an IC package is supported by a push-up lever portion which performs a seesaw motion at one end of the seesaw lever, the push-up lever portion being sprung up by rendering force for pushing down a push-down lever portion which performs a seesaw motion at the other end of the seesaw lever to push up the IC package. Accordingly, the IC package is always easily and surely pushed up in association with the seesaw motion of the seesaw lever and pushed up to a high position by, a predetermined amount, thereby to fascilitate the removal of the IC package.

Furthermore, the IC package pushing up amount can be optionally set by setting the seesaw motion amount of the seesaw lever. Besides, the setting can be easily and satisfactorily performed. Accordingly, it is very easy to manufacture.

## Claims

1. A socket in which a socket substrate (1) includes an IC package accommodating section (1a), and contact means (1b) for contacting terminal means (5a) of an IC package (5) which is accommodated in the IC package accommodating section, characterized in that

said socket includes a seesaw lever (3) for pushing up the IC package ;

said seesaw lever is formed at one end thereof with an IC package push-up lever portion (3b) disposed below said IC package accommodated in said IC package accommodating section and at the other end thereof with a push-down lever portion (3c) ;

said IC package push-up lever portion and said push-down lever portion are able to move up and down in turn like a seesaw motion balancing on a support (1c) disposed at a center between said lever portions ;

said socket substrate is provided with push-down means (2f) for rendering a push-down force to said push-down lever portion ; and said push-down means pushes down said push-down lever portion to spring up said IC package push-up lever portion, so that said IC package will be pushed up.

2. A socket as claimed in claim 1, characterized in that it further includes an IC package mounting table (4) for mounting said IC package thereon and movable in the vertical direction, said IC package mounting table with said IC package mounted thereon being pushed up by said IC package push-up lever portion.

3. A socket as claimed in claim 1 or claim 2, characterized in that a pair of said seesaw levers are provided on a diagonal line of said IC package accommodating section.

4. A socket as claimed in claim 1, 2 or 3, characterized in that it includes a framework (2) provided on said socket substrate, said framework being provided with said push-down means.

## Ansprüche

1. Fassung, in der ein Fassungsträger (1) einen einen IC-Baustein aufnehmenden Abschnitt (1a) sowie Kontaktmittel (1b) für den Kontakt mit Anschlußmitteln (5a) eines IC-Bausteins (5) umfaßt, der sich in dem den IC-Baustein aufnehmenden Abschnitt befindet, dadurch gekennzeichnet,

daß die Fassung einen Wipphebel (3) zum Aufwärtstreiben des IC-Bausteins enthält,

daß der Wipphebel an seinem einen Ende mit einem Aufwärtstreibhebelteil (3b) für den IC-Baustein versehen ist, der unterhalb des sich in dem Abschnitt befindlichen IC-Bausteins angeordnet ist, während sich am anderen Ende des Wipphebels ein Abwärtstreibhebelteil (3c) befindet ;

daß der Aufwärtstreibhebelteil für den IC-Baustein und der Abwärtstreibhebelteil in der Lage sind, sich abwechselnd in einer Wippbewegung auf- und abzubewegen und auf einem Auflager (1c) balancieren, das sich in einem Zentrum zwischen den Hebelteilen befindet ;

daß der Fassungsträger mit Abwärtstreibmitteln (2f) versehen ist, um eine Abwärtstreibkraft auf den Abwärtstreibhebelteil auszuüben ;

und daß die Abwärtstreibmittel den Abwärtstreibhebelteil nach unten treiben, so daß der Aufwärtstreibhebelteil für den IC-Baustein nach oben schnellt und der IC-Baustein nach oben getrieben wird.

2. Fassung nach Anspruch 1, dadurch gekennzeichnet, daß sie ferner einen IC-Baustein-Lagertisch (4) zur Lagerung des IC-Bausteins darauf enthält, der in vertikaler Richtung bewegbar ist, und daß der IC-Baustein-Lagertisch mit dem darauf befindlichen IC-Baustein durch den Aufwärtstreibhebelteil für den IC-Baustein nach oben getrieben wird.

3. Fassung nach Anspruch 1 oder 2, dadurch gekennzeichnet, daß zwei Wipphebel auf einer diagonalen Linie des den IC-Baustein aufnehmenden Abschnittes vorgesehen sind.

4. Fassung nach Anspruch 1, 2 oder 3, dadurch gekennzeichnet, daß diese ferner einen Rahmen (2) enthält, der auf dem Fassungsträger angeordnet ist, und der mit den Abwärtstreibmitteln versehen ist.

## Revendications

1. Un support dans lequel un substrat de support (1) comprend une section de réception de boîtier de circuit intégré (1a), et des moyens de contact (1b) destinés à venir en contact avec des bornes (5a) d'un boîtier de circuit intégré (5) qui est logé dans la section de réception de boîtier de circuit intégré, caractérisé en ce que

ce support comprend un levier basculant (3) pour pousser le boîtier de circuit intégré vers le haut ;

le levier basculant comporte à l'une de ses extrémités une partie de levier de poussée vers le haut de boîtier de circuit intégré (3b) qui se trouve au-dessous du boîtier de circuit intégré qui est logé dans la section de réception de boîtier de circuit intégré, et il comporte à son autre extrémité une partie de levier de poussée vers le bas (3c) ;

la partie de levier de poussée vers le haut de boîtier de circuit intégré et la partie de levier de poussée vers le bas sont capables de se déplacer tour à tour vers le haut et vers le bas, avec un mouvement de bascule, avec pivotement sur un point d'appui (1c) qui se trouve dans une partie centrale entre les parties de levier ;

le substrat de support comporte des moyens de poussée vers le bas (2f) qui sont destinés à appliquer une force de poussée vers le bas à la partie de levier de poussée vers le bas ; et

les moyens de poussée vers le bas poussent vers le bas la partie de levier de poussée vers le bas, pour soulever la partie de levier de poussée vers le haut de boîtier de circuit intégré, de façon que le boîtier de circuit intégré soit poussé vers le haut.

2. Un support selon la revendication 1, caractérisé en ce qu'il comprend en outre une table de montage de boîtier de circuit intégré (4), prévue pour recevoir le boîtier de circuit intégré, et mobile dans la direction verticale, cette table de montage de boîtier de circuit intégré, avec le boîtier de circuit intégré monté sur elle, étant poussée vers le haut par la partie de levier de poussée vers le haut de boîtier de circuit intégré.

3. Un support selon la revendication 1 ou la revendication 2, caractérisé en ce qu'une paire de leviers basculants sont disposés sur une diagonale de la section de réception de boîtier de circuit intégré.

4. Un support selon la revendication 1, 2 ou 3, caractérisé en ce qu'il comprend en outre un cadre (2) monté sur le substrat de support, et ce cadre est équipé des moyens de poussée vers le bas.

# F I G. 1

# F I G. 2 A

## F I G. 2 B

## F I G. 2 C

## F I G. 2 D

## F I G. 3

FIG. 4

FIG. 5

FIG. 6

FIG. 7

9

## FIG. 8

## FIG. 9

F I G. IO

F I G. II

# F I G. 12 A

# F I G. 12 B

# FIG. 13 A

# FIG. 13 B

# FIG. 14 A

# FIG. 14 B